Europäisches Patentamt

European Patent Office

Office européen des brevets

(11) Publication number:

**0 295 944**
**A2**

## (12) EUROPEAN PATENT APPLICATION

(21) Application number: 88305559.2

(22) Date of filing: 17.06.88

(51) Int. Cl.⁴: **G 03 C 1/68**
**G 03 F 7/10**

(30) Priority: 18.06.87 US 64092

(43) Date of publication of application:
21.12.88 Bulletin 88/51

(84) Designated Contracting States:
AT BE CH DE ES FR GB GR IT LI LU NL SE

(71) Applicant: NAPP SYSTEMS (USA) INC.
360 South Pacific Vista
California 92068 (US)

(72) Inventor: Wagner, William R.
1225 Via Ramon
Escondido California (US)

(74) Representative: Goldin, Douglas Michael et al
J.A. KEMP & CO. 14, South Square Gray's Inn
London WC1R 5EU (GB)

(54) Photosensitive resin composition and printing plate prepared therefrom.

(57) A water-developable, photopolymerizable composition comprises an ethylene-acrylic acid copolymer, a nitrogen-containing compound capable of neutralizing the acrylic acid component of the copolymer, a reactive ethylenically unsaturated monomer or monomer combinations, and a photoinitiator activatable by actinic light. A printing plate coated with the composition is suited for use with water-containing emulsion inks for letterpress printing.

EP 0 295 944 A2

**Description**

## PHOTOSENSITIVE RESIN COMPOSITION AND PRINTING PLATES PREPARED THEREFROM

### FIELD OF THE INVENTION

This invention relates to a photopolymerizable or photosensitive resin composition for the manufacture of printing plates, especially relief printing plates. Printing plates prepared from the photopolymerizable composition are characterized by excellent resistance to water-containing inks and also as being capable of development with water.

### BACKGROUND OF THE INVENTION

In the use of relief printing plates, it is highly desirable to use a photopolymerizable resin composition that may be developed using water, rather than organic solvents. The use of solvent-based developing solutions is quite objectionable as they can contribute to health problems and other detrimental environmental considerations. Moreover, the use of an organic solvent as the developing medium renders the development or "washout" process considerably more complex, because preparation of the chemical developing solution is complicated and presents a host of serious problems. In contrast, photopolymerizable compositions that can be developed with water avoid troublesome preparation problems as well as the workplace and environmental problems referred to previously.

Prior to this invention, a number of attempts have been made to provide a satisfactory photopolymerizable composition for relief printing. Thus, compositions are well-known which have utilized a liquid unsaturated polyester base, a polyvinyl alcohol base, a water-soluble nylon base, a cellulose acetate saxinate base, and an alcohol soluble nylon base. All such materials, however, have significant disadvantages.

The liquid polyester is inconvenient to handle, because it is a liquid, and it also requires the use of an alkaline solution or a special air knife for developing. Polyvinyl alcohol base materials and water-soluble nylon base materials, while capable of being developed with water, have extremely low resistance to water, and consequently cannot be used satisfactorily with water-containing inks. The cellulose acetate saxinate base material requires using an alkaline solution to develop, and the alcohol-soluble nylon base requires using an inflammable alcohol solution, both of which are objectionable.

In United States patent 3,801,328, the disclosure of which is incorporated herein by reference, a water-developable, photopolymerizable composition is described utilizing unsaturated ethylenic monomers, a photopolymerization initiator, and a partially saponified polyvinyl acetate. Printing plates prepared utilizing such photopolymerizable composition have met with significant commercial success and are particularly satisfactory for the production of letterpress printing plates. However, the water resistance of the surface of plates prepared from such composition is relatively low, which in turn precludes its effective use with water-based or emulsion inks.

Water-containing emulsified inks, however, offer potential print quality improvements over standard oil-based inks, insofar as letterpress printing is concerned. The introduction of water to oil-based ink formulations has been demonstrated to improve print smoothness and solid density and to reduce rub-off and ink misting. In view of such factors, it is clearly desirable to have a water-developable, photopolymerizable composition which is satisfactory for the preparation of relief printing plates and which has sufficient water resistance to be satisfactory for use with water-containing inks. The present invention thus addresses that need.

### SUMMARY OF THE INVENTION

This invention relates to a water-developable, photopolymerizable or photosensitive composition suitable for use with water-containing inks. The composition comprises a copolymer of ethylene and acrylic acid, a nitrogen-containing compound which is capable of neutralizing the acrylic acid component of the copolymer, mono- and/or polyfunctional ethylenically unsaturated monomers, and a photoinitiator that is activated by actinic light. Printing plates prepared from such compositions are developable with water and are also water resistant following development.

### DESCRIPTION OF PREFERRED EMBODIMENTS

As indicated above, the photopolymerizable composition of this invention includes an ethylene-acrylic acid copolymer. The acrylic acid component of the copolymer is at least approximately 15% by weight of the total weight of the copolymer, preferably approximately 20% by weight. To obtain water dispersibility, which is necessary for the water development of the final composition, the acrylic acid content must be at least approximately 50% neutralized by the addition of a base. Further, the developing water temperature must be higher than the copolymer's melting temperature. Ethylene-acrylic acid copolymers which contain less than approximately 15% acrylic acid by weight do not disperse well into water and require the use of emulsifiers to form less stable emulsions. Suitable materials are available from the Dow Chemical Company. One particularly suitable such copolymer is identified as Dow EAA copolymer 60751.10 and contains approximately 20% acrylic acid by weight. The ethylene-acrylic acid copolymers are water-dispersible, thermoplastic materials having hot melt adhesive properties. The melting temperature of the copolymer, important for dispersion into water as described above, is determined by its average molecular weight. The melting temperature of EAA copolymer 60751.10 is approximately 75°C.

As a neutralizing agent or compound, it has been found that nitrogen containing compounds, such as amines, are satisfactory. Especially suitable neutralizing agents are amino-containing monomers having an $\alpha$, $\beta$-ethylenically unsaturated bond, especially tertiary amine compounds. Illustrative examples are diethylaminoethyl acrylate, dimethylaminopropyl methacrylamide, dimethylaminoethyl methacrylate, t-butylaminoethyl methacrylate, and combinations of such monomers. When using the ethylene-acrylic acid copolymer identified above, it has been found that dimethylaminopropyl methacrylamide is an especially satisfactory neutralizing agent. When utilizing this particular amine, satisfactory dispersion in water is obtained at temperatures approximately equal to or even somewhat lower than the melting temperature of the copolymer. The acrylamide portion of this compound is also available for polymerization when the composition is exposed to a suitable light source. It has also been found that combinations of the foregoing amines can be used satisfactorily as neutralizing agents, with one particularly useful combination being dimethylaminopropyl methacrylamide and diethylaminoethyl methacrylate in an approximately 3:1 to 4:1 ratio. Such a combination has been found to wash out at acceptable temperatures, while also exhibiting much less swelling in water than utilizing dimethylaminopropyl methacrylamide alone.

Non-polymerizable amine compounds, such as diethanolamine, triethanolamine, N,N-dimethylaminoethanol, and 1-(N,N-dimethylamino)-2-propanol, were found to be ineffective as neutralizing agents in the present application. Addition of these materials to the resin formulation resulted in the production of a cloudy, incompatible material with poor processing properties.

The photopolymerizable composition also includes ethylenically unsaturated monomers which serve to impart toughness, hardness, structural integrity, and water-resistance to the resulting polymer, as well as lowering the viscosity of the unreacted resin. Examples of suitable monomers include unsaturated carboxylic monoesters such as the acrylic acid or methacrylic acid esters of organic alcohols including, for example, the acrylic or methacrylic acid esters of t-butanol, n-hexanol, cyclohexanol, 2-ethylhexyl alcohol, isobornyl alcohol, isooctyl alcohol, isodecyl alcohol, lauryl alcohol, and stearyl alcohol. Also suitable are the acrylic acid or methacrylic acid monoesters of aliphatic glycols and glycol esters, including, for example, the acrylic or methacrylic acid monoesters of ethylene glycol, propylene glycol, polyethylene glycol, and polypropylene glycol. Examples of suitable polyfunctional monomers are ethylene glycol diacrylate, 1,4-butanediol diacrylate, 1,6-hexanediol diacrylate, tripropylene glycol diacrylate, trimethylolpropane diacrylate, neopentylglycol dipropoxy diacrylate, trimethylolpropane triacrylate, pentaerythritol triacrylate, pentaerythritol tetraacrylate, ethylene glycol dimethacrylate, 1,4-butanediol dimethacrylate, 1,6-hexanediol dimethacrylate, diethylene glycol dimethacrylate, trimethylolpropane dimethacrylate, ethylene glycol dihydroxyethyl dimethacrylate, trimethylolpropane trimethacrylate, pentaerythritol trimethacrylate, pentaerythritol tetramethacrylate, and divinylbenzene. One or more of the monomers described above may be used in a given resin composition.

It may also be desirable to include a plasticizer in the photopolymerizable composition, although it is not essential to do so in all instances. Plasticizers, of course, impart flexibility to the resulting resin, improve flow characteristics, thereby making easier the task of molding plates, and increase processing speed. Any of a number of available plasticizers can be utilized, including polyethylene glycol, polypropylene glycols, e.g., polypropylene glycols having average molecular weights of about 426 and 2,000, nonanoic acid, decanoic acid, undecanoic acid, coconut fatty acids, sorbitol, tris(2-ethylhexyl)phosphate, di-n-butyl phthalate, polyethoxy benzoates, polyethoxy alkylbenzoates, polyethoxy phenolates, and polyethoxy alkylphenolates.

The photopolymerization initiator may be any of a number of such materials, such as acetophenone, benzophenone, benzoin or derivatives thereof, and benzil and benzil compounds. Illustrative acetophenone derivatives include 2,2-diethoxyacetophenone, 2,2-dimethoxy-2-phenylacetophenone (also referred to as benzil dimethyl ketal), 2,2-diethoxy-2-phenylacetophenone, and the like, while benzophenone derivatives suitable for use in the present invention include benzophenone, 2-methylbenzophenone, 2-methoxybenzophenone, and the like. Benzoin derivatives include methyl, ethyl, isopropyl, and n-butyl esters of benzoin, as for example, benzoinmethylether, benzoinethylether, benzoinisopropylether, benzoin-n-butylether, etc. Other initiators may also be utilized, such as benzil, 2-ethylanthraquinone, 1-hydroxycyclohexylphenylketone, and xanthones such as xanthone, thioxanthone, 2-chlorothioxanthone, and 2-isopropylthioxanthone. The initiators may be used alone or in combination with one another.

The photopolymerizable composition may also include a thermal polymerization inhibitor such as phenol derivatives, as for example, p-methoxyphenol, hydroquinone derivatives, benzoquinone derivatives, 2,6-di-t-butyl-p-cresol, and nitroso compounds.

The photopolymerizable composition may also include, as an additive, stearic acid, which has been shown to aid in the washout of the plates. By the same token, the composition, after application to the supporting substrate, may have applied thereto a matte surface to prevent sticking of a negative film to the resin surface during exposure, such as described and claimed in United States patent application Serial No. 908,567, filed September 18, 1986, entitled "Photopolymer Printing Plate With Matte Surface," and assigned to the same assignee as this invention. As the supporting substrate, any of the metallic plates, such as aluminum or stainless steel commonly used in the industry may be utilized, as can available plastic substrates. The substrate will ordinarily have an adhesive and/or a primer coating applied thereto prior to application of the photopolymerizable composition, all as is known and well understood in the art.

The photopolymerizable composition will typically include from about 50 to about 75% by weight, based on the total weight of the composition, of the ethylene-aorylic acid copolymer, from about 20 to about 30% by weight of the amine-containing neutralizing compound, approximately 6 to about 35% by weight of the ethylenically unsaturated monomer or monomer combination, from about 3 to about 20% by weight of the plasticizer, and from about 0.1 to about 7% by weight of the photoinitiator. If a thermal polymerization inhibitor is utilized, it will ordinarily be present in a small quantity; for example, from about 0.001 to about 1.0% preferably from about 0.005 to about 0.5% by weight.

The photosensitive resin composition is obtained by intimate mixing of the foregoing components in any suitable mixing apparatus, as is known and understood by those skilled in the art. Following mixing, the composition may be applied to a supporting substrate by extrusion or calendering to form an even layer of approximately 0.01 to about 10 mm thickness. To produce an image, the substrate containing the photopolymerizable composition is exposed to ultraviolet light through a negative film in the conventional manner. Polymerization occurs in the areas exposed to the ultraviolet light, thus creating a polymerized image which is not soluble in water or alkaline solution. The unexposed and unpolymerized portions of the plate surface are removed by washing in water at a temperature within the range of about 50°C to about 60°C for about 1 to 10 minutes, to produce a relief printing plate with high resistance to water. Following drying in the standard manner, the relief image thus formed has been found to be quite satisfactory and is compatible with water-containing emulsion inks as well as standard oil-based inks.

The invention will be better understood by reference to the following specific, but illustrative examples.

Example 1

The photopolymerizable composition was prepared by mixing the following ingredients in the indicated parts by weight:

|  | Parts |
| --- | --- |
| Ethylene-acrylic acid copolymer (20% acrylic acid) | 60.0 |
| Dimethylaminopropyl methacrylamide | 28.4 |
| Trimethylolpropane triacrylate | 6.0 |
| Benzil dimethyl ketal | 1.5 |
| p-Methoxyphenol | 0.1 |

The resulting composition was molded by calendering onto a primer coated steel plate of approximately 0.18 mm thickness to provide a total thickness of approximately 0.5 mm. A negative film was placed in contact with the photosensitive surface under a vacuum to insure good contact. The composition was exposed through the negative film using an ultraviolet lamp for about one minute, after which the negative film was removed. The plate was then washed with water at about 54°C for approximately two minutes to obtain a relief image faithful to the negative film and having a Shore A hardness of about 55°. The plate exhibited excellent water resistance. A sharp printed image was obtained using this plate on a letterpress printing press using water-emulsified and oil-based inks.

Example 2

The procedure described in Example 1 was again followed to produce the following printing plate composition:

|  | Parts |
|---|---|
| Ethylene-acrylic acid copolymer<br>    (20% acrylic acid) | 60.0 |
| Dimethylaminopropyl methacrylamide | 20.0 |
| Diethylaminoethyl methacrylate | 5.0 |
| Trimethylolpropane triacrylate | 6.0 |
| Polyethoxy phenolate | 3.0 |
| Benzil dimethyl ketal | 1.5 |
| Stearic acid | 1.0 |
| Di-t-butylcresol | 0.2 |

The resulting plate was exposed through a negative film as described in Example 1. The film was removed and the plate was washed with 57°C water for about 5 minutes. The resulting sharp relief image displayed superior water-resistance.

Example 3

The procedure described in Example 1 was again followed to produce the following printing plate, except that the total thickness was about 0.7 mm:

|  | Parts |
|---|---|
| Ethylene-acrylic acid copolymer<br>    (20% acrylic acid) | 60.0 |
| Dimethylaminopropyl methacrylamide | 25.0 |
| Tripropylene glycol methacrylate | 10.0 |
| Diethylene glycol dimethacrylate | 5.0 |
| Polyethoxy alkylphenolate | 5.0 |
| Benzil dimethyl ketal | 1.5 |
| Stearic acid | 1.0 |
| Di-t-butylcresol | 0.2 |

The resulting plate was exposed through a negative film as described in Example 1. The film was removed and the plate was washed with 57°C water for about 9 minutes to produce a sharp relief image. Plates prepared in this manner were mounted on a newspaper letterpress press. Approximately 25,000 impressions were printed at a press speed in excess of 1,000 feet/minute using emulsion and oil-based inks. The print showed a sharp image without signs of plate deterioration.

It will thus be appreciated from the foregoing, including especially the illustrative examples, that the photopolymerizable composition of the present invention enables printing plates to be prepared that are not only developable with water but are also quite water resistant and capable of use with water-emulsified inks, as well as oil-based inks.

While specific embodiments of this invention have been described herein, it is to be understood that modifications and equivalents of such embodiments as will be apparent to those skilled in the art are intended to be within the scope of this invention. For example, the invention described herein utilizes copolymers of ethylene and acrylic acid. As has been discussed, the water-developability of the photosensitive resin, as pertains to the characteristics of the base polymer, is determined by the average molecular weight and by the acid group content. As such, it will be understood by those skilled in the art that the use of copolymers of other functionally equivalent comonomers such as methacrylic acid or olefins other than ethylene, for example, are also within the scope of the invention.

## Claims

1. A water-developable, photopolymerizable composition, comprising an ethylene-acrylic acid copolymer containing at least about 15% by weight acrylic acid, a nitrogen-containing compound capable of neutralizing the acrylic acid component of said copolymer, mono- or poly-functional ethylenically unsaturated monomers or combinations thereof, and a photoinitiator activatable by actinic light.

2. A composition according to claim 1 in which said nitrogen-containing compound is an amine-containing monomer having an $\alpha$, $\beta$-ethylenically unsaturated bond.

3. A composition according to claim 2 in which said amine-containing monomer is a tertiary amine containing monomer.

4. A composition according to claim 2 in which said amine-containing monomer is selected from diethylaminoethyl acrylate, dimethylaminopropyl methacrylamide, dimethylaminoethyl methacrylate, t-butylaminoethyl methacrylate, and combinations thereof.

5. A composition according to any one of the preceding claims in which said ethylene acrylic acid copolymer has approximately 15 to about 25% by weight acrylic acid.

6. A composition according to any one of the preceding claims in which said monofunctional monomer or monomers is selected from unsaturated carboxylic esters such as the acrylic or methacrylic acid esters of organic alcohols, including for example, the acrylic or methacrylic acid esters of t-butanol, n-hexanol, cyclohexanol, 2-ethylhexyl alcohol, isobornyl alcohol, isooctyl alcohol, isodecyl alcohol, lauryl alcohol, stearyl alcohol, and the unsaturated carboxylic esters of aliphhatic glycols and glycol ethers including, for example, the acrylic or methacrylic acid esters of ethylene glycol, propylene glycol, 1,4-butanediol, polyethylene glycol, and polypropylene glycol.

7. A composition according to any one of the preceding claims in which said polyfunctional monomer is selected from ethylene glycol diacrylate, 1,4-butanediol diacrylate, 1,6-hexanediol diacrylate, tripropylene glycol diacrylate, trimethylolpropane triacrylate, pentaerythritol triacrylate, pentaerythritol tetraacrylate, ethylene glycol dimethacrylate, 1,4-butanediol dimethacrylate, 1,6-hexanediol dimethacrylate, diethylene glycol dimethacrylate, trimethylolpropane dimethacrylate, ethylene glycol dihydroxyethyl dimethacrylate, trimethylolpropane trimethacrylate, pentaerythritol trimethacrylate, pentaerythritol tetramethacrylate, and divinyl-benzene.

8. A composition according to any one of the preceding claims in which the photoinitiator is acetophenone, benzophenone or benzoin or derivative thereof, benzil, or a benzil compound.

9. A composition according to claim 8 in which the photoinitiator is 2,2-dimethoxy-2-phenylacetophenone.

10. A composition according to claim 1 suitable for use with water-containing emulsion inks, comprising an ethylene-acrylic acid copolymer containing at least approximately 15% by weight acrylic acid, an amine-containing monomer having an $\alpha,\beta$-ethylenically unsaturated bond capable of neutralizing the acrylic acid component of said copolymer, monofunctional and/or polyfunctional unsaturated monomers capable of serving as a polymerizable agent and a photoinitiator activatable by actinic light.

11. A composition according to claim 10 in which said amine containing monomer is dimethylaminopropyl methacrylamide.

12. A printing plate comprising a substrate coated with a composition according to any one of the preceding claims.